# EUROPEAN PATENT SPECIFICATION

(11) **EP 3 851 822 B1**
(45) Date of publication and mention of the grant of the patent: **25.02.2026**
(21) Application number: 21150139.0
(22) Date of filing: 05.01.2021
(51) Int. Cl.: G01L 9/00

(54) **MEMS THIN MEMBRANE WITH STRESS STRUCTURE**
MEMS-DÜNNMEMBRAN MIT SPANNUNGSSTRUKTUR
MEMBRANE MINCE MEMS AVEC STRUCTURE DE CONTRAINTE

(30) Priority: 15.01.2020 US 202062961510 P; 08.12.2020 US 202017115137
(43) Date of publication of application: 21.07.2021
(73) Proprietor: STMicroelectronics Pte Ltd., Singapore 569508 (SG)
(72) Inventor: SHANKAR, Ravi, 600275 Singapore (SG); LOH, Tien Choy, 737882 Singapore (SG); VENKATESAN, Ananya, 541272 Sengkang Central (SG)
(74) Representative: Cabinet Beaumont

(56) References cited:
- EP-A1- 3 095 754
- US-A- 6 056 888
- US-A1- 2003 213 288
- US-A1- 2012 227 505
- US-B2- 9 674 627

## Description

### TECHNICAL FIELD

The present invention generally relates to miniature sensors and, in particular to a microelectromechanical system (MEMS) pressure sensor.

### BACKGROUND

There are many applications which require the sensing of pressure. It is known in the art to use a suspended membrane as a pressure sensor. However, the performance of such sensors in terms of sensitivity and range is less than optimal. There is a need in the art for a pressure sensor, especially one of the microelectromechanical system (MEMS) type, having improved sensitivity and range.

US 2012/0227505A1 describes a miniature high sensitivity pressure sensor. EP 3 095 754A1 describes a low pressure sensor and flow sensor. Further state of the art is known from US 6056888A and US 2003/213288A1.

### SUMMARY

A sensor is provided as defined in claim 1.

According to embodiment, each piezoresistor is formed by a doped region at the topside surface of the thin membrane.

According to embodiment, the blind opening defines the thin membrane to have, in plan view, a quadrilateral shape.

According to embodiment, the stress structure is mounted to the topside surface of the thin membrane and the induced bending of the thin membrane forms a concave shape at the topside surface and a convex shape at the bottomside surface.

According to embodiment, the sensor functions to sense pressure applied in a direction towards the bottomside surface which produces a bending of the thin membrane away from the normal state.

According to embodiment, the stress structure is mounted to the bottomside surface of the thin membrane and the induced bending of the thin membrane forms a concave shape at the bottomside surface and a convex shape at the topside surface.

According to embodiment, the sensor functions to sense pressure applied in a direction towards the topside surface which produces a bending of the thin membrane away from the normal state.

According to an embodiment, each piezoresistor is formed by a doped region at the topside surface of the semiconductor membrane.

According to an embodiment, the opening defines the membrane to have, in plan view, a quadrilateral shape.

The stress structure, in plan view, has a round shape.

The stress structure, in plan view, further includes one or more arms which radially extend from the round shape.

### BRIEF DESCRIPTION OF THE DRAWINGS

For a better understanding of the embodiments, reference will now be made by way of example only to the accompanying figures in which:
Figures 1-3 show steps of a process for forming a microelectromechanical system (MEMS) pressure sensor;
Figures 4-5 illustrate a response of the sensor of Figure 3 to the application of pressure;
Figures 6-10B show steps of a process for forming a microelectromechanical system (MEMS) pressure sensor;
Figures 11A and 11B illustrate a response of the sensor of Figures 10A and 10B, respectively, to the application of pressure; and
Figures 12A-12C (12A and 12B are outside of the scope of the claims) are plan views showing example layouts for the stress structure with piezoresistors in a bridge circuit configuration for the sensor.

### DETAILED DESCRIPTION

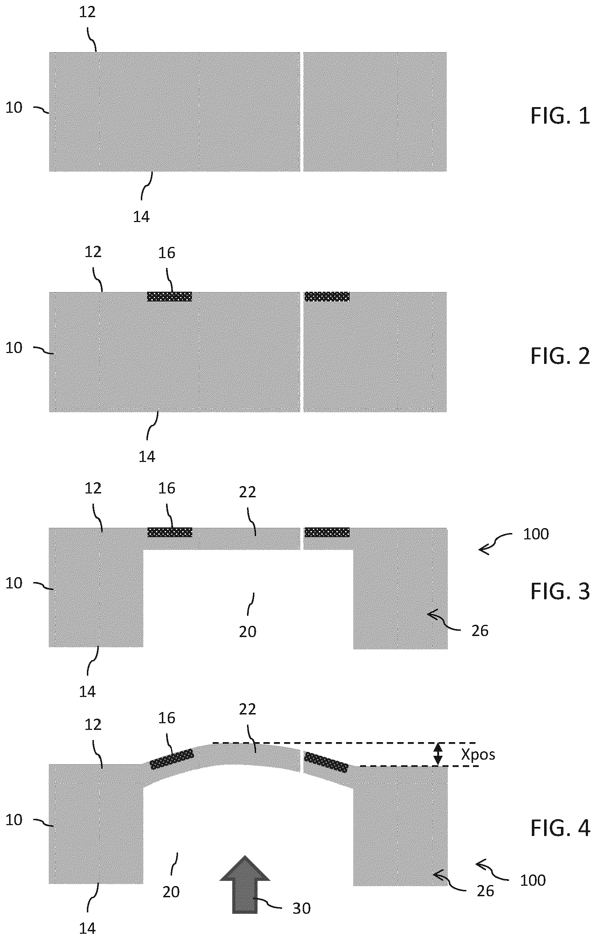

Reference is made to Figures 1-3 which show steps in a process for forming a microelectromechanical system (MEMS) pressure sensor 100. Figure 1 shows a semiconductor substrate 10 that is, for example, made of silicon. The substrate 10 may, if desired, be lightly doped with a dopant of a first conductivity type (for example, n-type) or may be left as intrinsic semiconductor material. The substrate 10 includes a top surface 12 and a bottom surface 14. Using a conventional lithographic process, a plurality of doped regions 16 are formed in the substrate 10 at the top surface 12. The doped regions 16 may, for example, be formed using a masked implantation and activation of a dopant of a second conductivity type (for example, p-type). As an example, the doped regions 16 have a dopant concentration suitable for forming a resistive semiconductor structure. The result is shown in Figure 2. The bottom surface 14 of the substrate 10 is then micromachined in order to selectively thin the substrate 10 and form a blind opening (or cavity) 20 extending into the substrate from the bottom surface 14, where the blind opening defines a thin membrane 22 at the top surface 12. The thin membrane 22 has a thickness which permits bending in response to application of a pressure to be sensed. The plurality of doped regions 16 are located within the area of the thin membrane 22 at the top surface 12. The result is shown in Figure 3. The portions of the substrate 10 which are not thinned form a substrate frame 26 from which the thin membrane 22 is suspended. The substantially flat shape of the thin membrane 22 as shown in Figure 3 is the normal or initial state of the sensor 100.

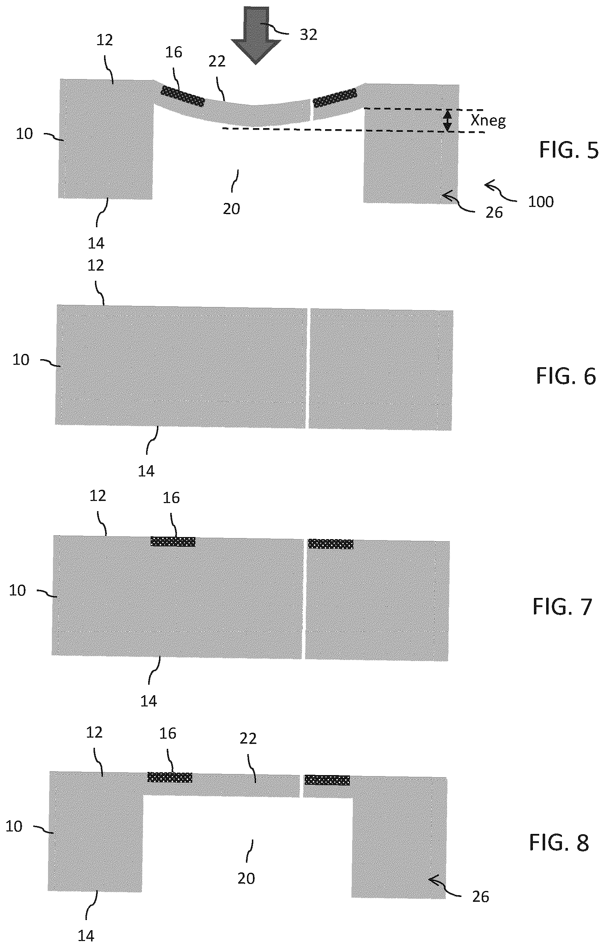

By making an electrical connection to the doped region 16 at two distinct, spaced apart, locations, each doped region 16 may form a semiconductor resistor (for example, of the piezoresistive type) such that the resistance between the two electrical connections varies as a function of displacement (i.e., bending) of the thin membrane 22. The thin membrane 22 may be bent in a first direction, away from the normal or initial state, in response to a pressure 30 applied in the direction of the bottom surface 14 as shown in Figure 4. The amount of displacement Xpos by which the thin membrane 22 is bent is a function of the magnitude of the applied pressure 30, and the change of resistance of the piezoresistive resistors formed by the included doped regions 16 will correspondingly vary as a function of the magnitude of the applied pressure 30. The thin membrane 22 may also be bent in a second direction, opposite the first direction, away from the normal or initial state, in response to a pressure 32 applied to the top surface 12 as shown in Figure 5. The amount of displacement Xneg by which the thin membrane 22 is bent is a function of the magnitude of the applied pressure 32, and the change of resistance of the piezoresistive resistors formed by the included doped regions 16 will correspondingly vary as a function of the magnitude of the applied pressure 32. It will be noted that the sensitivity range for the sensor 100 is limited by the maximum value of the amount of displacement (Xpos, or Xneg) due to the bending of the thin membrane 22.

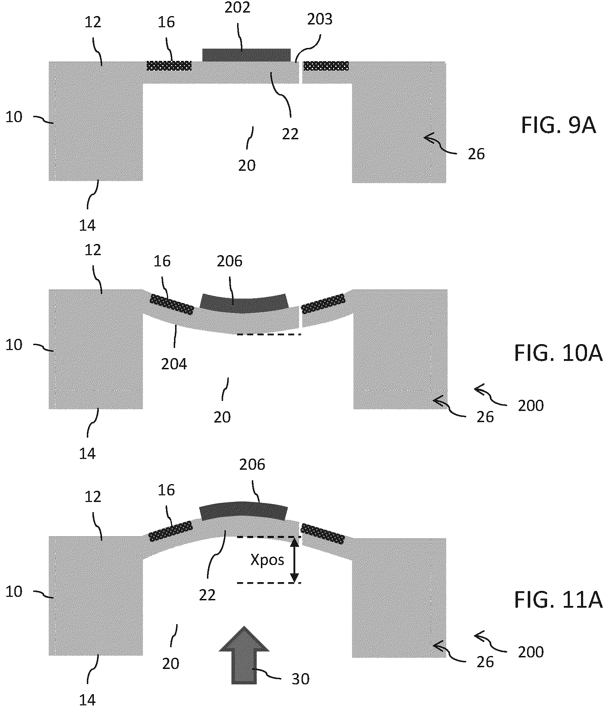

Reference is made to Figures 6-10B which show steps in a process for forming a microelectromechanical system (MEMS) pressure sensor 200. Figure 6 shows a semiconductor substrate 10 that is, for example, made of silicon. The substrate 10 may, if desired, be lightly doped with a dopant of a first conductivity type (for example, n-type) or may be left as intrinsic semiconductor material. The substrate 10 includes a top surface 12 and a bottom surface 14. Using a conventional lithographic process, a plurality of doped regions 16 are formed in the substrate 10 at the top surface 12. The doped regions 16 may, for example, be formed using a masked implantation and activation of a dopant of a second conductivity type (for example, p-type). As an example, the doped regions 16 have a dopant concentration suitable for forming a resistive semiconductor structure. The result is shown in Figure 7. The bottom surface 14 of the substrate 10 is then micromachined in order to selectively thin the substrate 10 and form a blind opening (or cavity) 20 extending into the substrate from the bottom surface 14, wherein the blind opening defines a thin membrane 22 at the top surface 12. The thin membrane has a thickness which permits bending in response to application of a pressure to be sensed. The plurality of doped regions 16 are located within the area of the thin membrane 22 at the top surface 12. The result is shown in Figure 8. The portions of the substrate 10 which are not thinned form a substrate frame 26 from which the thin membrane 22 is suspended. Next, a layer 202 of a material is deposited on a topside surface 203 of the thin membrane 22 in the middle of the area of the thin membrane 22. The deposited material may, for example, comprise a polyimide. The area occupied by the layer 202 is less than the area of the thin membrane 22. The result is shown in Figure 9A. A curing process is then performed with respect to the layer 202 and as a result the layer 202 shrinks to form a stress structure 206 which induces a deformation of the thin membrane 22 due to residual stress with a convex shape on the bottomside surface 204 of the thin membrane 22 (and a concave shape on the topside surface 203 of the thin membrane 22). The result is shown in Figure 10A. The deformed shape of the thin membrane 22 as shown in Figure 10A is the normal or initial state of the sensor 200. The curing process may comprise, after deposition of the layer 202, a prebake (for example, at a temperature of about 240°C), followed by an exposure to ultra-violet light in a contact aligner (with a dose of about 420 mj), followed by an atmospheric oven bake (for example, at a temperature of about 350°C).

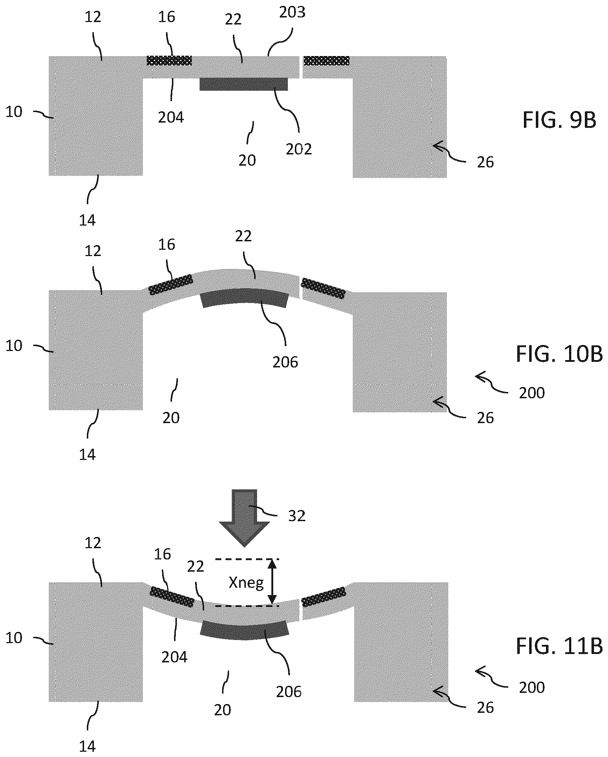

In an alternative embodiment, the layer 202 of the material is deposited within the opening 20 on the bottomside surface 204 of the thin membrane 22 in the middle of the area of the thin membrane 22. Again the deposited material may comprise a polyimide, and the area occupied by the layer 202 is less than the area of the thin membrane 22. The result is shown in Figure 9B. The curing process as discussed above is then performed to form a stress structure 206 which induces a deformation of the thin membrane 22 due to residual stress with a convex shape on the topside surface 203 of the thin membrane 22 (and a concave shape on the bottomside surface 204 of the thin membrane 22). The result is shown in Figure 10B. The deformed shape of the thin membrane 22 as shown in Figure 10B is the normal or initial state of the sensor 200.

It will be noted that in the normal or initial state of the sensor 200, for each of the embodiments shown by Figures 10A and 10B, the stress structure 206 is located on the surface of the thin membrane 22 which is associated with the concave shape as a result of the residual stress from the stress structure. The opposite surface of the thin membrane 22, which is associated with the convex shape, forms the pressure sensing surface of the sensor 200. Thus, in the Figure 10A embodiment the bottomside surface 204 of the thin membrane 22 is the pressure sensing surface, while in the Figure 10B embodiment the topside surface 203 of the thin membrane 22 is the pressure sensing surface. The use of the stress structure 206 forms a sensor where the thin membrane 22 is biased in a deformed shape for the normal or initial state, deflects from that deformed shape in response to an applied pressure at the convex shaped surface (in an opposite direction from the deformed shape) and is resilient so as to return to that deformed shape when the pressure is removed.

It is important to note that the thinning of the substrate 10 to form the blind opening 20 must be controlled so as to set the thickness of the thin membrane 22 in a manner which permits the stress structure 206 to induce the required degree of deformation of the thin membrane 22 for the normal or initial state.

By making an electrical connection to the doped region 16 at two distinct, spaced apart, locations, each doped region 16 may form a semiconductor resistor (for example, of the piezoresistive type) such that the resistance between the two electrical connections varies as a function of displacement (i.e., bending) of the thin membrane 22. With respect to the embodiment of the sensor 200 as shown in Figure 10A, the thin membrane 22 may be bent in a direction opposite the biased deformation induced by the stress structure 206, which defines the normal or initial state, in response to a pressure 30 applied in the direction of the bottom surface 14 as shown in Figure 11A. The amount of displacement Xpos by which the thin membrane 22 bends is a function of the magnitude of the applied pressure 30, and the change of resistance of the piezoresistive resistors formed by the included doped regions 16 will correspondingly vary as a function of the magnitude of the applied pressure 30. It will be noted that the magnitude of the displacement Xpos for the bending in Figure 11A in response to the applied pressure is substantially greater (for example, at about 2X) the magnitude of displacement Xpos of the bending in Figure 4. Thus, the sensor 200 exhibits a greater sensitivity and range than the sensor 100.

With respect to the embodiment of the sensor 200 as shown in Figure 10B, the thin membrane 22 may be bent in a direction opposite the biased deformation induced by the stress structure 206, which defines the normal or initial state, in response to a pressure 32 applied in the direction of the top surface 12 as shown in Figure 11B. The amount of displacement Xneg by which the thin membrane 22 bends is a function of the magnitude of the applied pressure 32, and the change of resistance of the piezoresistive resistors formed by the included doped regions 16 will correspondingly vary as a function of the magnitude of the applied pressure 32. It will be noted that the magnitude of displacement Xneg for the bending in Figure 11B is substantially greater (for example, at about 2X) the magnitude of displacement Xneg of bending in Figure 5. Thus, the sensor 200 exhibits a greater sensitivity and range than the sensor 100.

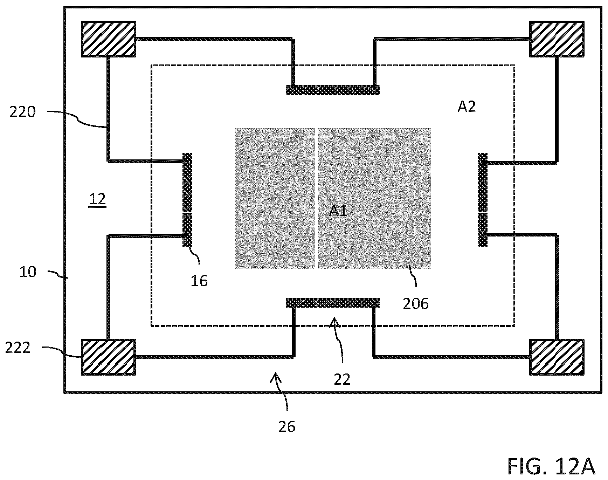

Reference is now made to Figure 12A which is a plan view showing an example layout of the stress structure 206 with piezoresistors in a bridge circuit configuration for the sensor, which is outside of the scope of the claims. The sensor includes four doped regions 16 forming four corresponding piezoresistors. The dotted line shows the area of the thin membrane 22 as defined by the opening 20. The stress structure 206 is shown in this view on the top surface 12 of the substrate 10 corresponding to the implementation of Figure 10A. However, it will be understood that the stress structure 206 could alternatively be positioned on the bottomside surface 204 in the opening 20 as shown in the implementation of Figure 10B.

The area A1 occupied by the stress structure 206 is less than the area A2 of the thin membrane 22. The stress structure 206 is offset from, and in a preferred embodiment centered between, the four doped regions 16. Indeed, in the preferred embodiment the geometric center of the area A1 occupied by the stress structure 206 coincides with the geometric center of the area A2 occupied by the thin membrane 22. The thin membrane 22 defined by the opening 20 and the stress structure 206 may each have, in plan view, a quadrilateral shape. The four doped regions 16 are arranged to longitudinally extend parallel to a corresponding side of the stress structure 206. Furthermore, a center of the longitudinal extension of each doped region 16 is located in alignment with the center of corresponding side of the thin membrane 22 in order to ensure maximal stress.

Circuit lines 220 are formed above, and insulated from, the top surface 12 of the substrate 10, with those circuit lines 220 interconnecting electrical connection pads 222 of the sensor to the four doped regions 16 through vias (not explicitly shown, but located at positions to make electrical contact to the spaced apart locations for each doped region 16). The electrical circuit formed by the illustrated electrical connections forms a resistive bridge circuit, and variation in the resistance of the bridge circuit can be sensed using a sensing circuit connected to the pads 222 in order to sense the applied pressure 30, 32.

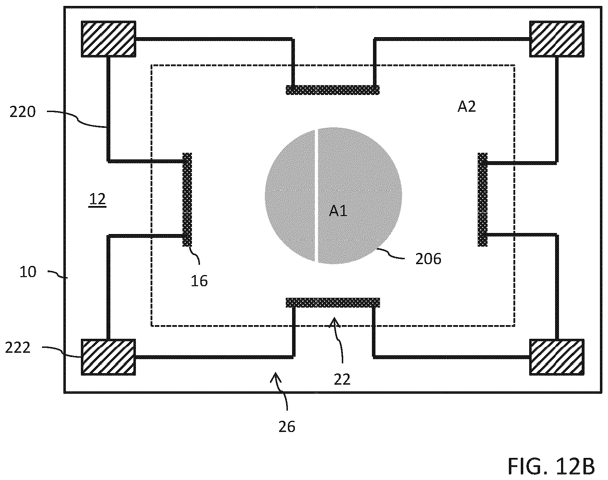

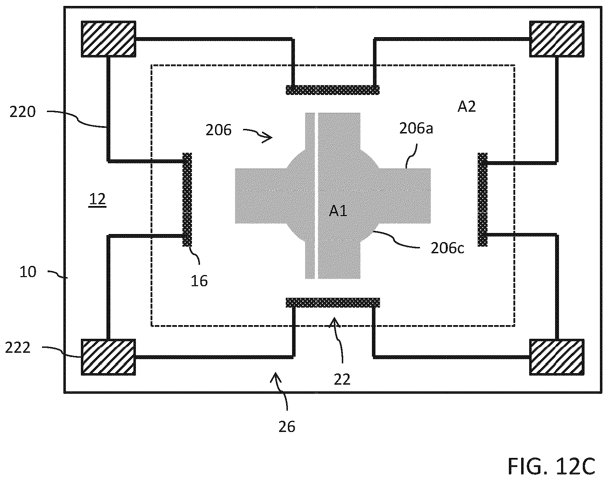

Figure 12A, which is outside of the scope of the claims, shows the plan view for the stress structure 206 having a quadrilateral shape (which may be rectangular (as show) or square, for example). In an alternative implementation shown in Figure 12B, which is outside of the scope of the claims, the stress structure 206 has a round shape in the plan view (where that round shape may be circular or ovular). The circular shape of the stress structure, for example, induces circular residual stress on the thin membrane 22 and this will alter both the response of the membrane to the applied pressure 30, 32 and variation in resistance of the piezoresistors to that membrane response. In an alternative implementation shown in Figure 12C, the stress structure 206 has a more complex shape in the plan view. The complex shape for the stress structure 206 comprises a central region 206c (which may have any desired shape including quadrilateral and round (as shown)) and one or more arms 206a which radially extend from the central region 206c. In a preferred implementation, each included radially extending arm 206a is oriented in a direction extending towards a corresponding one of the piezoresistors (that direction preferably being perpendicular to the longitudinal extension of the doped region forming the piezoresistor). The advantage of the complex shape for the stress structure 206 is that the arms 206a protrude residual stress further away from the geometric center of the thin membrane 22. It will be noted than an imbalance in the residual stress induced by the stress structure 206 can be applied by including less than four arms 206a and/or by having the included arms 206s present different radial lengths.

While the invention has been illustrated and described in detail in the drawings and foregoing description, such illustration and description are considered illustrative or exemplary and not restrictive; the invention is not limited to the disclosed embodiments.

## Claims

1. A sensor (200), comprising:
a semiconductor substrate (10) having a top surface (12) and a bottom surface (14) and including a blind opening (20) extending into the semiconductor substrate from the bottom surface, said blind opening defining a thin membrane (22) suspended from a substrate frame (26), wherein the thin membrane has a topside surface (203) and a bottomside surface (204);
a stress structure (206) mounted to one of the topside surface or bottomside surface of the thin membrane and configured to induce a bending of the thin membrane which defines a normal state for the thin membrane; and
a plurality of piezoresistors (16) supported by the thin membrane;
**characterized in that**
the stress structure (206), in plan view, has a round shape (206c) and further includes one or more arms (206a) which radially extend from the round shape.

2. The sensor (200) of claim 1, wherein the stress structure (206) is mounted to the topside surface (203) of the thin membrane (22) and the induced bending of the thin membrane forms a concave shape at the topside surface and a convex shape at the bottomside surface (204).

3. The sensor (200) of claim 2, wherein the sensor functions to sense pressure (30) applied in a direction towards the bottomside surface (204) which produces a bending of the thin membrane away from the normal state.

4. The sensor (200) of claim 1, wherein the stress structure (206) is mounted to the bottomside surface (204) of the thin membrane (22) and the induced bending of the thin membrane forms a concave shape at the bottomside surface and a convex shape at the topside surface (203).

5. The sensor (200) of claim 4, wherein the sensor functions to sense pressure (32) applied in a direction towards the topside surface (203) which produces a bending of the thin membrane away from the normal state.

6. The sensor (200) of anyone of claims 1 to 5, wherein each piezoresistor (16) is formed by a doped region at the topside surface of the membrane.

7. The sensor (200) of anyone of claims 1 to 6, wherein the opening (20) defines the membrane (22) to have, in plan view, a quadrilateral shape.

## Patentansprüche

1. Sensor (200), der folgendes aufweist:
ein Halbleitersubstrat (10) mit einer Oberseite (12) und einer Unterseite (14) und einer Blindöffnung (20), die sich von der Unterseite in das Halbleitersubstrat erstreckt, wobei die Blindöffnung eine dünne Membran (22) definiert, die an einem Substratrahmen (26) aufgehängt ist, wobei die dünne Membran eine Oberseite (203) und eine Unterseite (204) aufweist;
eine Spannungsstruktur (206), die an der Oberseite oder der Unterseite der dünnen Membran angebracht ist und konfiguriert ist zum Induzieren eines Biegens der dünnen Membran, was einen Normalzustand für die dünne Membran definiert; und
eine Vielzahl von Piezowiderständen (16), die von der dünnen Membran getragen werden;
**dadurch gekennzeichnet, dass**
die Spannungsstruktur (206) in der Draufsicht eine runde Form (206c) besitzt und ferner einen oder mehrere Arme (206a) aufweist, der/die sich radial von der runden Form erstreckt/erstrecken.

2. Sensor (200) nach Anspruch 1, wobei die Spannungsstruktur (206) an der Oberseite (203) der dünnen Membran (22) angebracht ist und das induzierte Biegen der dünnen Membran eine konkave Form an der Oberseite und eine konvexe Form an der Unterseite (204) bildet.

3. Sensor (200) nach Anspruch 2, wobei der Sensor dazu dient, einen in Richtung der Unterseite (204) ausgeübten Druck (30) zu erfassen, der ein Biegen der dünnen Membran aus ihrem Normalzustand heraus bewirkt.

4. Sensor (200) nach Anspruch 1, wobei die Spannungsstruktur (206) an der Unterseite (204) der dünnen Membran (22) angebracht ist und das induzierte Biegen der dünnen Membran eine konkave Form an der Unterseite und eine konvexe Form an der Oberseite (203) bildet.

5. Sensor (200) nach Anspruch 4, wobei der Sensor dazu dient, einen in Richtung der Oberseite (203) ausgeübten Druck (32) zu erfassen, der ein Biegen der dünnen Membran aus ihrem Normalzustand heraus bewirkt.

6. Sensor (200) nach einem der Ansprüche 1 bis 5, wobei jeder Piezowiderstand (16) durch einen dotierten Bereich an der Oberseite der Membran gebildet wird.

7. Sensor (200) nach einem der Ansprüche 1 bis 6, wobei die Öffnung (20) die Membran (22) so definiert, dass sie in der Draufsicht eine vierseitige Form aufweist.

## Revendications

1. Capteur (200), comprenant :
un substrat semiconducteur (10) ayant une surface supérieure (12) et une surface inférieure (14) et comportant une ouverture borgne (20) s'étendant à l'intérieur du substrat semiconducteur à partir de la surface inférieure, ladite ouverture borgne définissant une membrane mince (22) suspendue à un cadre de substrat (26), dans lequel la membrane mince a une surface supérieure (203) et une surface inférieure (204) ;
une structure de contrainte (206) montée sur l'une parmi la surface supérieure ou la surface inférieure de la membrane mince et configurée pour induire une flexion de la membrane mince qui définit un état normal pour la membrane mince ; et
une pluralité de piézorésistances (16) supportées par la membrane mince ;
**caractérisé en ce que**
la structure de contrainte (206), en vue de dessus, a une forme ronde (206c) et comporte en outre un ou plusieurs bras (206a) qui s'étendent radialement à partir de la forme ronde.

2. Capteur (200) selon la revendication 1, dans lequel la structure de contrainte (206) est montée sur la surface supérieure (203) de la membrane mince (22) et la flexion induite de la membrane mince forme une forme concave au niveau de la surface supérieure et une forme convexe au niveau de la surface inférieure (204).

3. Capteur (200) selon la revendication 2, dans lequel le capteur a pour fonction de détecter une pression (30) appliquée dans une direction vers la surface inférieure (204) qui produit une flexion de la membrane mince qui l'éloigne de l'état normal.

4. Capteur (200) selon la revendication 1, dans lequel la structure de contrainte (206) est montée sur la surface inférieure (204) de la membrane mince (22) et la flexion induite de la membrane mince forme une forme concave au niveau de la surface inférieure et une forme convexe au niveau de la surface supérieure (203).

5. Capteur (200) selon la revendication 4, dans lequel le capteur a pour fonction de détecter la pression (32) appliquée dans une direction vers la surface supérieure (203) qui produit une flexion de la membrane mince qui l'éloigne de l'état normal.

6. Capteur (200) selon l'une quelconque des revendications 1 à 5, dans lequel chaque piézorésistance (16) est formée par une région dopée au niveau de la surface supérieure de la membrane.

7. Capteur (200) selon l'une quelconque des revendications 1 à 6, dans lequel l'ouverture (20) définit la membrane (22) pour qu'elle ait, en vue de dessus, une forme quadrilatérale.
